# EUROPÄISCHE PATENTANMELDUNG

(11) **EP 1 229 558 A2**
(43) Veröffentlichungstag der Anmeldung: **07.08.2002**
(21) Anmeldenummer: 02002636.5
(22) Anmeldetag: 05.02.2002
(51) Int. Cl.: H01C 17/28, H01C 1/14

(54) **Herstellung niederohmiger Widerstände**

(30) Priorität: 05.02.2001 DE 10105106
(71) Anmelder: EasyMeter GmbH, 21079 Hamburg-Harburg (DE)
(72) Erfinder: Herrmann, Frank, 21493 Schwarzenbek (DE); Gabriel, Rupprecht, 33813 Oerlinghausen (DE)
(74) Vertreter: Leonhard, Frank Reimund, Dipl.-Ing.

(57) **Zusammenfassung**

Vorgeschlagen wird ein Verfahren zur Herstellung eines Widerstands, wobei zwei leitfähige Werkstoffe (10,15 ; 16,21) flach aufeinander gelegt werden und durch (mechanischen) Druck ineinander gepresst werden, zur Ausbildung eines ersten Widerstandabschnitts (28,25) und zweier in einem Abstand den ersten Abschnitt (28,25) zweiseitig begrenzender Anschlussabschnitte (27,26,23,24) für das Anschließen von Stromzuführungen. Ergebnis der Erfindung ist es, die Verbindung zwischen dem gut leitfähigem Anschlussteil (Anschlußbereich) des Widerstands und dem Widerstandskörper so auszubilden, dass preiswertere Verfahren für die Verbindung Anschlussbereich - Widerstandskörper eingesetzt werden können.

## Beschreibung

Die Erfindung betrifft ein Verfahren zur Herstellung von elektrischen Widerständen vorzugsweise ohmschen Widerständen im Mikro- oder Milliohmbereich. Solche niederohmigen Widerstände werden benötigt, um hohe Ströme messtechnisch zu erfassen. Dazu wird der Spannungsabfall über den Widerständen in 2- oder 4-Leitertechnik, nämlich mit getrennten Strom und Spannungsanschlüssen erfasst und einer weiterverarbeitenden Signalbearbeitung zugeleitet.

Die mit den hier beschriebenen Widerständen zu messenden AC- oder DC-Ströme liegen bevorzugt im Bereich zwischen einigen Ampere bis einigen 100 Ampere. Sie müssen dem Messwiderstand möglichst niederohmig zugeleitet werden, um anfallende Zuleitungsverluste zu minimieren.

Dazu werden in den bisher bekannten Verfahren gut leitfähige metallische Anschlussstücke, die eine niederohmigen Stromzuführung gewährleisten sollen, mit den eigentlichen Widerstandelementen bestehend aus Kupfer-Mangan-Nickel-Zinn-Legierungen, verbunden z.B. durch Hartlötung. Die Stromzuführung zum Widerstand erfolgt über Stromzuführungsleitungen, die mit dem gut leitfähigen Teil des Widerstands beispielsweise fest verschraubt oder verschweißt sind. Der Spannungsabgriff eines Widerstandes in 4-Leitertechnik wird in den bekannten Verfahren meist so dicht wie möglich am Widerstandselement platziert und besteht aus elektrisch leitenden Zuführungen, die auf beiden Seiten des genutzten Widerstandskörpers angebracht sind.

In **EP-A 605 800** wird ein anderes Verfahren beschrieben. Die niederohmigen Anschlüsse wurden nicht durch Hartlöten mit den einzelnen Widerstandskörpern verbunden, sondern die Widerstandskörper und die gut leitfähigen Teile des Widerstandes wurden in Bandform zueinander gebracht und zusammengeschweißt. Dazu wurden die Materialbänder aus den unterschiedlichen leitfähigen Materialien stumpf an ihren Längskanten zusammengelegt und durch verschiedene Schweißtechniken zusammengefügt. Ein Vorteil dieser Verfahrensweise liegt in der anschließenden Bearbeitbarkeit mit einem Stanz-Biegeautomaten für größere Mengen an Widerständen mit gleicher geometrischer Form.

Das Verfahren der Walzplattierung ist für die Fertigung von elektrotechnischen Massengüter sehr breit etabliert. Walzplattieren wird überall dort angewendet, wo Werkstoffe verschiedener physikalischer Eigenschaften schnell und sicher aufeinander gebracht werden sollen.

**Aufgabe der Erfindung** ist es, die Verbindung zwischen dem gut leitfähigem Anschlussteil (Anschlußbereich) des Widerstands und dem Widerstandskörper so auszubilden, das preiswertere Verfahren für die Verbindung Anschlussbereich - Widerstandskörper eingesetzt werden können.

Gemäß Anspruch 1 der Erfindung wird die Walzplattierung genutzt. Ein gut leitfähiges Basismaterial, z.B. Kupfer, für den niederohmigen Anschlussbereich des Widerstands und das eigentliche Widerstandsverbundmaterial werden nach einer Aufbereitung im Glühofen und einem Vorwalzprozess flach aufeinandergelegt und unter Druck im eigentlichen Walzprozess aufeinander plattiert (Anspruch 7).

Bei den bekannten Herstellungsverfahren ergaben sich bisher zwischen gut leitfähigem Material und Widerstandsmaterial Übergangsflächen, die sich eng begrenzt an den Kanten des Widerstandselements ausbildeten und deren Querschnitt auf die nötige Stromtragfähigkeit optimiert war. Die Stromflusslinien traten ohne nennenswerte Umlenkung vom gut leitfähigen Material senkrecht durch die Schweiß- oder Lötstelle in das Widerstandsmaterial ein, verliefen geradlinig weiter und traten auf der entgegengesetzten Widerstandsseite spiegelbildlich zur ersten Seite ohne Umlenkung senkrecht durch die Fügfläche wieder aus. Im eingangs beschriebenen Verfahren ergeben sich so durch die Wahl der zusammenzufügenden Bänder Schweißflächen, die an den Längskanten der Bänder ausgebildet waren.

In dem Verfahren gemäß Anspruch 1 oder 8 ergeben sich erfindungsgemäß Fügeflächen, die sich an der Oberfläche des flachen Widerstandskörpers befinden und nicht an den senkrecht dazu stehenden Querkanten gemäß den bekannten Verfahren. Durch das Walzplattieren werden die verschiedenen Materialien flach aufeinander gefügt, so dass die Grenzflächenstücke im wesentlichen senkrecht zur Quererstreckung des Widerstandabschnitts orientiert sind (Anspruch 7).

Stromflusslinien werden entsprechend des Anspruchs 1 und des Verfahrens nach Anspruch 8 nach dem Übergang vom leitfähigen Anschlussteil in das Widerstandsmaterial (um einen Winkel von ungefähr 90°) umgelenkt. Das gleiche passiert spiegelbildlich auf der gegenüberliegenden Austrittsfläche der Stromlinien.

Unter Bezugnahme auf die folgenden Zeichnungen wird die Erfindung an Beispielen näher erläutert. Die Zeichnungen zeigen:
- Fig. 1a: die erfindungsgemäß aufeinander gelegten verschieden leitfähigen Teile zur Herstellung des Widerstandes vor einer Walzplattierung,
- Fig. 1b: die walzplattierten Teile nach der Herstellung des Widerstandes,
- Fig. 2a: die aufeinandergelegten verschieden leitfähigen Teile zur Herstellung einer zweiten Widerstands-Ausführung vor der Walzplattierung,
- Fig. 2b: die walzplattierten Teile nach der Herstellung der zweiten Ausführung,
- Fig. 2c: in einem ersten Teilbild die aufeinandergelegten Teile zur Herstellung einer weiteren Widerstands-Ausführung, bei der das Widerstandsmaterial in das leitfähige Material eingewalzt wird, vor der Walzplattierung und in zwei Teilbildern nach der Aufwalzung,
- Fig. 3a: aufeinander gelegte verschieden leitfähigen Teile zur Herstellung des Widerstandes vor der Walzplattierung in einem Mehrfachnutzen,
- Fig. 3b: die walzplattierten Teile nach der Herstellung des Mehrfachnutzens,
- Fig. 3c: die Trennstellen und die Trennung dieses Mehrfachnutzens,
- Fig. 4a: die aufeinander gelegten verschieden leitfähigen Teile zur Herstellung einer Widerstands-Ausführung vor der Walzplattierung mit einer dritten Schicht,
- Fig. 4b: die walzplattierten Teile mit der dritten Schicht nach der Herstellung der Widerstandsanordnung,
- Fig. 5a: ein weiteres Beispiel eines Widerstands im Querschnitt und in der Sicht von unten (2 Teilbilder),
- Fig. 5b: ein weiterer Widerstand im Querschnitt und in der Topansicht (2 Bilder).

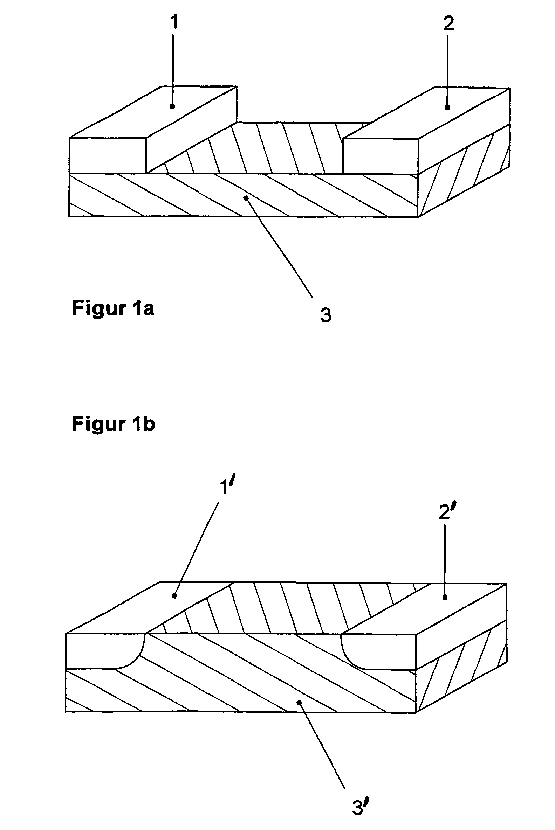

In Fig. 1a ist der Zustand der beiden leitfähigen Materialien gezeigt, die über eine Walzplattierung zusammengefügt werden sollen. Die Materialien 1, 2 sind entweder aus gut leitfähigem Werkstoff vorzugsweise aus Kupfer und bilden später den Anschlussbereich des Widerstandes oder sind aus Widerstandsmaterial und bilden später den Widerstandskörper des Bauteils. 3 ist das andere metallische Material entweder das eigentliche Widerstandsmaterial vorzugsweise eine Kupfer-Mangan- oder Kupfer-Nickel-Legierung oder der gut leitfähige Werkstoff. 1, 2 werden in Streifenform ausgeführt und in Walzrichtung auf das plattenförmige andere Material gelegt. Fig. 1b zeigt die Anordnung aus Fig. 1a nach der Walzplattierung. Das Material 1', 2' ist erfindungsgemäß in das Material 3' einplattiert. Die Gesamtdicke der Anordnung in Fig. 1b ergibt sich aus dem gewählten Walzdruck. Die geometrische Form wird durch die Seitenführung im Werkzeug der Walzplattiereinrichtung bestimmt. Um die Führung der beiden Materialien während des Walzplattierens weiter zu verbessern, kann das streifenförmige Material in eine vorher gefräste Vertiefung in der anderen Materialplatte eingelegt werden.

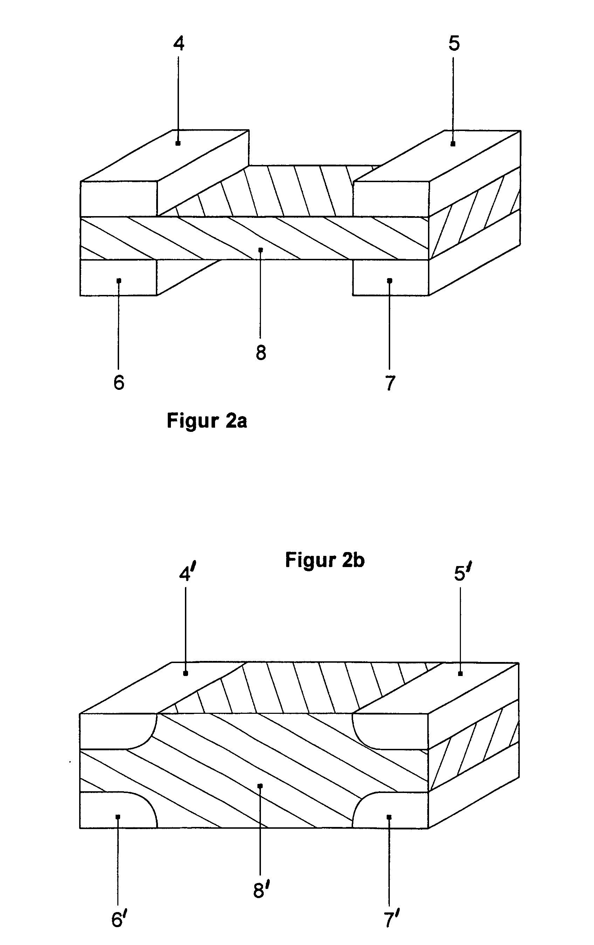

Fig. 2a zeigt eine Anordnung für die Plattierung des Anschlussbereiches von Widerständen auf Ober- und Unterseite des Widerstandsmaterials. Die gut leitfähigen Streifen 4, 5, 6 und 7 werden in das Widerstandsmaterial 8 von beiden Seiten eingewalzt z.B. um so einen niederohmigen Anschlussbereich zu erhalten. Nach dem Walzvorgang ergibt sich die in Fig. 2b gezeigte Form. Die Anschlussbereiche 4', 5', 6' und 7' sind beidseitig in die Platte 8' aus Widerstandsmaterial eingewalzt.

Die Anordnung aus Fig. 2a und 2b kann in einem Mehrfachnutzen plaziert werden.

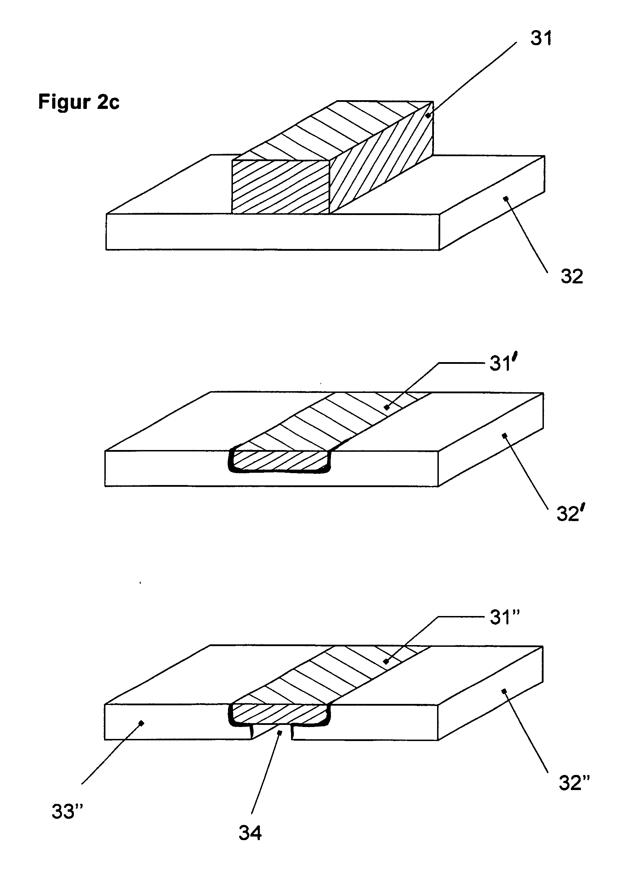

Fig. 2c zeigt eine alternative Anordnung aus Widerstandsmaterial 31 und gut leitfähigem Material 32 bei der auf eine beidseitige Plattierung verzichtet wird und trotzdem ein sehr niederohmiger Anschlussbereich 32" und 33" entsteht. Nach dem Walzvorgang ist das Material 31' in die Materialplatte 32' eingewalzt. Um den elektrischen Widerstand zu erhalten, wird das gut leitende Material vom Widerstandsmaterial in der Nut 34" entfernt. Es entstehen so die niederohmigen Anschlussbereiche 32" und 33".

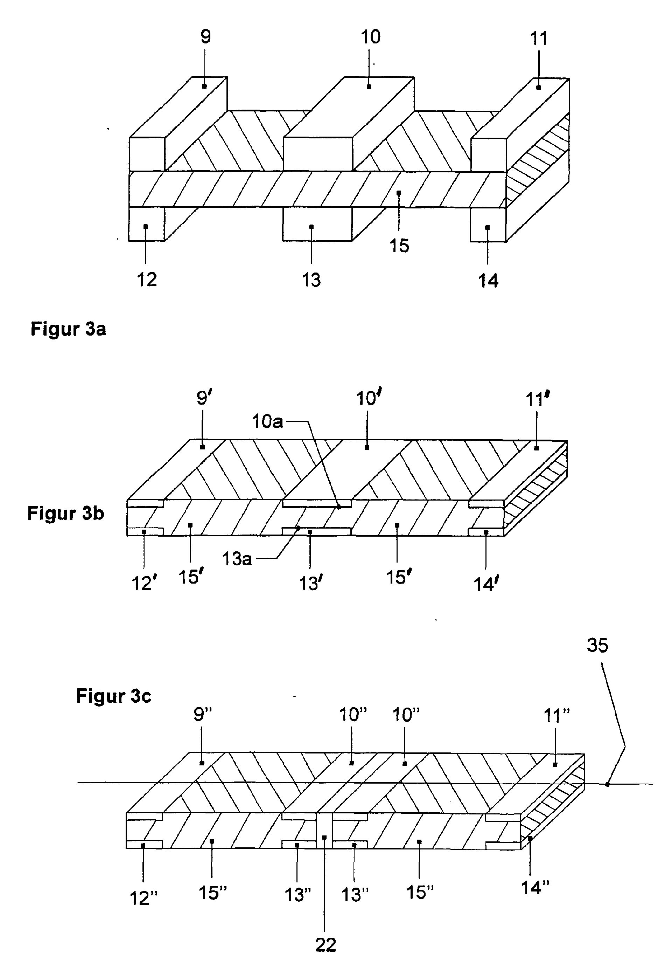

Fig. 3a zeigt beispielhaft eine Anordnung im Doppelnutzen mit den gut leitfähigen Materialstreifen 9, 10, 11, 12, 13 und 14 sowie der Widerstandsplatte 15. Nach der Walzplattierung ergibt sich wiederum eine flache Struktur entsprechend Fig. 3b. Die leitfähigeren Anschlussbereiche 9', 10', 11', 12', 13' und 14' sind in die Widerstandsmaterialplatte 15' in bekannter Weise einplattiert.

Zur Vereinzelung der Widerstände wird die Anordnung nach Fig. 3b geteilt. Fig. 3c zeigt die vorzusehende Trennstelle 22 der Doppelnutzen-Anordnung, die sich in Walzrichtung der beiden zu plattierenden Materialien erstreckt.

Es ergeben sich nach der Trennung 2 Widerstandsstreifen: den Widerstandsstreifen 1 mit den Anschlussbereichen 9", 10", 12" und 13" und den Widerstandsstreifen 2 mit den Anschlussbereichen 10", 11", 13" und 14". In Fig. 3c erhält man beispielsweise vier Widerstände, indem die Widerstandsstreifen an der Trennstelle 35 z.B. durch Stanzen getrennt werden. Der Abstand weiterer zur Trennlinie 35 paralleler Trennlinien wird so gewählt, dass sich der gewünschte Widerstandswert durch die Breite der Abstanzungen 9", 10",12", 13" und 15" ergibt.

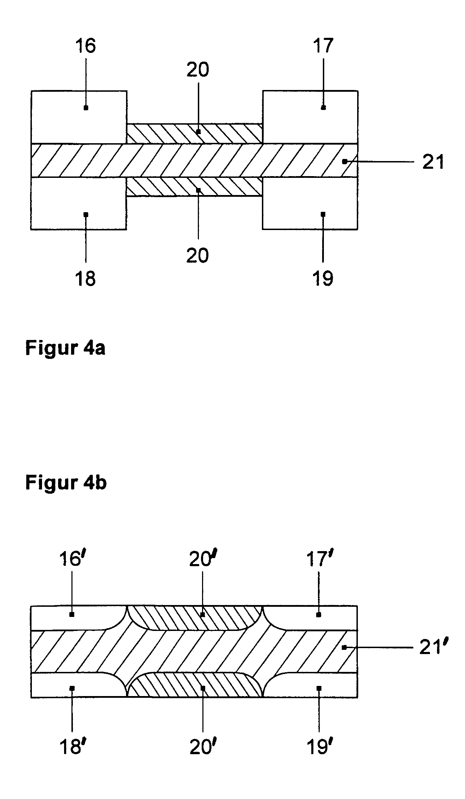

Fig. 4 zeigt die in Fig. 2a gezeigte Ausführung. Die Materialien 16, 17, 18 und 19 sind die gut leitfähigen metallischen Streifen und 21 ist das Widerstandsmaterial vor dem Plattieren. In der Anordnung nach Fig. 4 ist eine erfindungsgemäß zusätzliche dritte Schicht 20 ergänzt z.B. aus anorganischem Isoliermaterial, die ein- oder beidseitig im Bereich des Widerstandskörpers 21 vor dem Plattieren zum Schutz der Widerstandsoberfläche aufgelegt ist. Die Schicht kann auch aus einem weiteren Widerstandsmaterial bestehen und so die Mischeigenschaft beider Widerstandswerkstoffe kombiniert werden. In Fig. 4b sind die Schichten aufeinander gewalzt. Die bearbeitete Widerstandsplatte zeigt die Anschlussbereiche 16', 17', 18' und 19', den Widerstandsbasiskörper 21' und die dritte Schicht 20'.

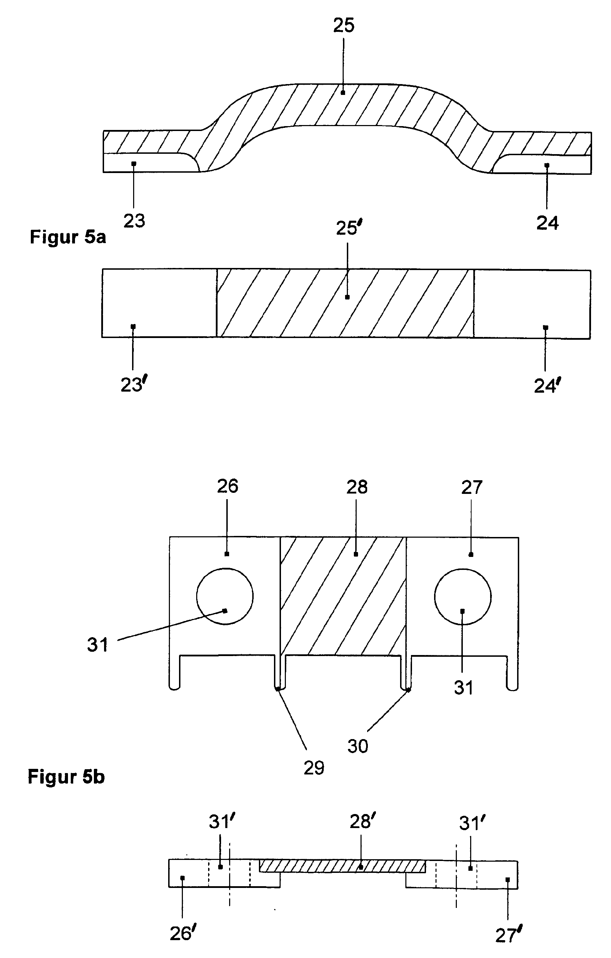

Fig. 5 zeigt zwei besonders ausgeführte Mess-Widerstände R. Die Widerstände sind entweder aus einem Mehrfachnutzen vereinzelt, oder einzeln hergestellt worden. Der Widerstand in Fig. 5a bestehend aus den Anschlussbereichen 23 und 24 und dem Widerstandskörper 25. In der Ansicht von unten sind die leitfähigen Flächen 23' und 24' zu erkennen, die flach auf eine leitfähigen Fläche aufgelötet werden können, z.B. auf eine Leiterkarte. Der Widerstand hat wie in Fig. 5 gezeigt eine Kröpfung, damit der Widerstandskörper 25' nicht mit der Leiterkarte in Kontakt tritt.

Es kann für diesen Zweck auch eine weitere Schicht wie in Fig. 4b einplattiert werden.

Der Widerstand in Fig. 5b zeigt eine Anordnung, die aufrecht in eine leitfähige Unterlage eingelötet werden kann. Der Widerstand besteht aus den gut leitenden Anschlussbereichen 26 und 27 mit 2 Bohrungen 31 für den Anschluss von stromzuführenden Leitungen, dem eigentlichen Widerstandskörper 28 und den beiden Spannungsanschlüssen 29 und 30.

Der Widerstand ist in Vierleitertechnik ausgeführt und besteht aus den beiden Stromzuführungen, die an die Bohrungen 31 angeschraubt werden und den beiden Spannungsabgriffen 29 und 30.

Die Abgriffe 29 und 30 sind jeweils in den Übergangsbereichen der beiden aufplattierten Materialien platziert und geeignet, um direkt in Leiterkarten eingelötet zu werden. Darunter ist der Widerstand in Topansicht gezeigt.

Die gut leitfähigen Anschlüsse für die Stromzuführungen 31' sind mit den beiden Bohrungen 26' und 27' versehen. In das gut leitfähige Material wurde das Widerstandsmaterial 28' eingewalzt und im Bereich des Widerstandskörpers 28' teilweise von der Materialschicht 26', 27' befreit z.B. durch Schaben oder Fräsen.

Die Widerstände aus Fig. 5 können aus einem Mehrfachnutzen bevorzugt durch Stanzen vereinzelt werden.

## Patentansprüche

1. **Verfahren zum Herstellen** von niederohmigen elektrisch leitenden Widerständen (Widerstandselement) für elektrische Messzwecke, wobei ein aus einem Widerstandsmaterial, wie Widerstandslegierung, bestehendes Stangen- oder Plattenmaterial mit einem (demgegenüber) besser leitenden Material für niederohmige Anschlussstellen des zu fertigenden (späteren) Widerstandselements verbunden wird,
**dadurch gekennzeichnet, dass** in das oder auf das Widerstandsmaterial durch ein Walzplattieren ein bzw. das andere leitfähige Material ein- oder aufgewalzt wird.

2. Verfahren nach Anspruch 1, **dadurch gekennzeichnet, dass** das eine leitende Material von beiden gegenüberliegenden Seiten in das andere Material eingewalzt wird.

3. Verfahren nach Anspruch 1 oder 1 und 2, bei dem mehrere Streifen unterschiedlicher Leitfähigkeit in einem Vorgang nebeneinander eingewalzt werden.

4. Verfahren nach Anspruch 1 und 2 **dadurch gekennzeichnet, dass** nach dem Einwalzen der Materialien ineinander in einer Ausführungsform im Bereich des Widerstandskörpers das andere leitende Material teilweise von dem Widerstandsmaterial entfernt wird.

5. Verfahren nach Anspruch 1 oder 1 und 2, bei dem Widerstände durch Stanzen bzw. Stanzbiegen aus dem Verbundmaterial ausgestanzt werden, wobei der Widerstand im 4-Draht Anschluss betrieben wird und seine Spannungs-Anschlüsse an der Grenzfläche des höher leitfähigen Materials liegen.

6. Verfahren nach 1 sowie 1 und 2, bei dem durch eine dritte walzplattierte Schicht der Gesamtwiderstand, die Lötfähigkeit, der Korrosionsschutz bzw. die mechanische Stabilität beeinflusst wird.

7. **Messwiderstand** (R), hergestellt nach einem der vorigen Ansprüche, zur Verwendung als Shunt oder bei der Strommessung, mit zumindest zwei Fügeflächen (10a, 13a) als Grenzflächenstücke, die im wesentlichen parallel zu einer Erstreckung eines den elektrischen Widerstand bildenden Abschnitts (28,25) des Messwiderstandes verlaufen.

8. **Verfahren zur Herstellung** eines Widerstands, wobei zwei leitfähige Werkstoffe (10,15 ; 16,21) flach aufeinander gelegt werden und durch (mechanischen) Druck ineinander gepresst werden,
zur Ausbildung eines ersten Widerstandabschnitts (28,25) und zweier in einem Abstand den ersten Abschnitt (28,25) zweiseitig begrenzender Anschlussabschnitte (27,26;23,24) für das Anschließen von Stromzuführungen.

9. Meßwiderstand nach Anspruch 7, wobei die Erstreckung die Längserstreckung (in Stromrichtungsfluß) des Widerstandabschnitts ist.

10. Verfahren nach Anspruch 8, zur Herstellung eines Widerstandes nach Anspruch 7.
